# FASCICULE DE BREVET EUROPEEN

(11) **EP 1 547 136 B1**
(45) Date de publication et mention de la délivrance du brevet: **30.12.2009**
(21) Numéro de dépôt: 03780284.0
(22) Date de dépôt: 02.10.2003
(51) Int. Cl.: H01L 21/306, H01L 21/321, H01L 23/525

(54) **PROCEDE DE FABRICATION DE NANO-STRUCTURE FILAIRE DANS UN FILM SEMI-CONDUCTEUR.**
VERFAHREN ZUR HERSTELLUNG EINER DRAHTFÖRMIGEN NANOSTRUKTUR AUS EINER HALBLEITENDEN SCHICHT
METHOD FOR MAKING A WIRE NANOSTRUCTURE IN A SEMICONDUCTOR FILM

(30) Priorité: 03.10.2002 FR 0212235
(43) Date de publication de la demande: 29.06.2005
(73) Titulaire: COMMISSARIAT A L'ENERGIE ATOMIQUE, 75015 Paris (FR)
(72) Inventeur: FRABOULET, David, 38950 Quai-en-Chartreuse (FR); GAUTIER, Jacques, 38500 Coublevie (FR); TONNEAU, Didier, 13009 Marseille (FR); CLEMENT, Nicolas, 83000 Toulon (FR); BOUCHIAT, Vincent, 38330 Biviers (FR)
(74) Mandataire: Poulin, Gérard
(86) Numéro de dépôt international: PCT/FR2003/050072
(87) Numéro de publication internationale: WO 2004/032182

(56) Documents cités:
- EP-A- 0 557 590
- K. YAGI ET AL: "Step bunching, step wandering and facetting : self-organization at Si surfaces" SURFACE SCIENCE REPORTS, vol. 43, 2001, pages 45-126, XP002287321 AMSTERDAM
- SAMESHIMA T ET AL: "RAPID CRYSTALLIZATION OF SILICON FILMS USING ELECTRICAL-CURRENT-INDUCED JOULE HEATING" JOURNAL OF APPLIED PHYSICS, AMERICAN INSTITUTE OF PHYSICS. NEW YORK, US, vol. 89, no. 10, 15 mai 2001 (2001-05-15), pages 5362-5367, XP001049075 ISSN: 0021-8979
- OGAWA T ET AL: "REAL-TIME OBSERVATION OF ELECTRON-BEAM INDUCED MASS TRANSPORT IN STRAINED INGAAS/ALGAAS LAYERS ON GAAS (100) AND (311)B SUBSTRATES" JAPANESE JOURNAL OF APPLIED PHYSICS, PUBLICATION OFFICE JAPANESE JOURNAL OF APPLIED PHYSICS. TOKYO, JP, vol. 38, no. 2B, PART 1, février 1999 (1999-02), pages 1040-1043, XP000934464 ISSN: 0021-4922

## Description

### Domaine technique et art antérieur

L'invention concerne un procédé de fabrication de nano-structure filaire dans un film semi-conducteur.

L'invention trouve une application particulièrement avantageuse pour la réalisation de nano-circuits et, plus particulièrement, pour la réalisation de nano-circuits MOS (MOS pour «Métal Oxyde Semi-conducteur »).

Selon l'art connu, la fabrication de nano-structures filaires dans les films semi-conducteurs s'effectue par lithographie DUV (DUV pour « Deep Ultra Violet »), par lithographie par faisceau d'électrons, ou encore par alternance de lithographie et de lithogravure masquée. Dans ce dernier cas, il est alors possible de doubler la résolution des structures obtenues.

Les plus petites nano-structures filaires obtenues à ce jour ont une largeur sensiblement égale à 100nm.

Cette limitation s'oppose à la conception de nano-circuits de dimensions plus petites ayant, par exemple, des dimensions de l'ordre de la dizaine de nanomètres.

L'invention ne présente pas cet inconvénient.

L'article de K. Yagi "Step burching, step wandering and facetting : self-organization at Si Surface", Surface Science Reports, 43 (2001), 45-126, donne on aperçu de phénomènes induits par effet Joule dans le silicium.

### Exposé de l'invention

En effet, l'invention concerne un procédé de fabrication de nano-structure filaire. Le procédé comprend :
- la fabrication d'un film mince semi-conducteur s'étendant entre une première borne et une deuxième borne, et le passage d'un courant entre la première et la deuxième borne de façon à former au moins une surépaisseur continue dans le film mince semi-conducteur, par migration, sous l'action du courant, d'une fraction du matériau semi-conducteur, la surépaisseur continue se formant selon la direction du courant qui parcourt le film, et la gravure du film mince, après la formation de la surépaisseur continue, pour former au moins un nanofil.

L'invention concerne également un procédé de gravure de couche par masque dur qui utilise comme masque dur une nano-structure filaire obtenue par le procédé de fabrication de nano-structure filaire selon l'invention.

Selon le mode de réalisation préférentiel de l'invention, le semi-conducteur est du silicium monocristallin dopé n. D'autres modes de réalisation sont également possibles, comme cela apparaîtra à la lecture de la description qui va suivre.

### Brève description des figures

D'autres caractéristiques et avantages de l'invention apparaîtront à la lecture d'un mode de réalisation préférentiel fait en référence aux figures jointes, parmi lesquelles :
- la figure 1 représente un film mince de semi-conducteur pour la réalisation d'une nano-structure filaire selon l'invention ;
- la figure 2 représente une nano-structure filaire obtenue suite au passage d'un courant dans un film mince de semi-conducteur tel que représenté en figure 1 ;
- la figure 3 représente une vue en coupe de la structure représentée en figure 2 ;
- la figure 4 représente une étape supplémentaire pour la formation de nano-fils à partir de la nano-structure filaire représentée en figure 2 ;
- les figures 5A et 5B représentent des étapes de gravure utilisant la nano-structure filaire obtenue précédemment comme masque de gravure.

### Description détaillée de modes de mise en oeuvre de l'invention

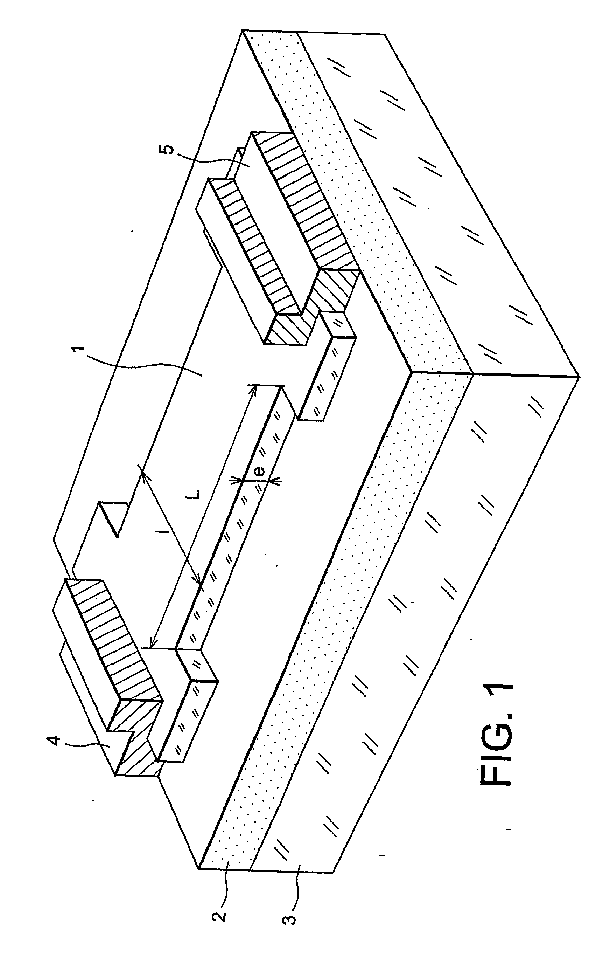

La figure 1 représente un film mince de semi-conducteur pour la réalisation d'une nano-structure filaire selon l'invention.

Selon le mode de réalisation préférentiel de l'invention, le film mince de semi-conducteur 1 est un film mince de silicium monocristallin dopé n. Le film mince de silicium monocristallin dopé n est formé sur une couche de silice 2 (SiO₂) qui est elle-même formée sur une couche épaisse de silicium 3. La formation du film mince de silicium monocristallin dopé est réalisée par toute technique connue de lithographie et/ou par tout procédé connu de gravure. Il peut s'agir, par exemple, de la technique de lithographie AFM (AFM pour « Atomic Force Microscope ») qui est décrite dans l'article intitulé « Electronic transport properties of single-crystal silicon nanowires fabricated using an atomic force microscope », publié dans Physica E, vol.13, 999-1002 (2002). Le film mince de semi-conducteur monocristallin dopé 1 est connecté, à une première extrémité, à une première borne 4 et, à une deuxième extrémité, à une deuxième borne 5. Les bornes 4 et 5 constituent des contacts électriques conducteurs. Elles sont réalisées, par exemple, en silicium dégénéré.

A titre d'exemple non limitatif, les résultats qui vont être donnés ci-après correspondent à un film mince de silicium monocristallin dopé n, d'épaisseur e typiquement comprise entre 15 et 20nm, de largeur 1 sensiblement égale à 0,7µm et de longueur L sensiblement égale à 1,3µm.

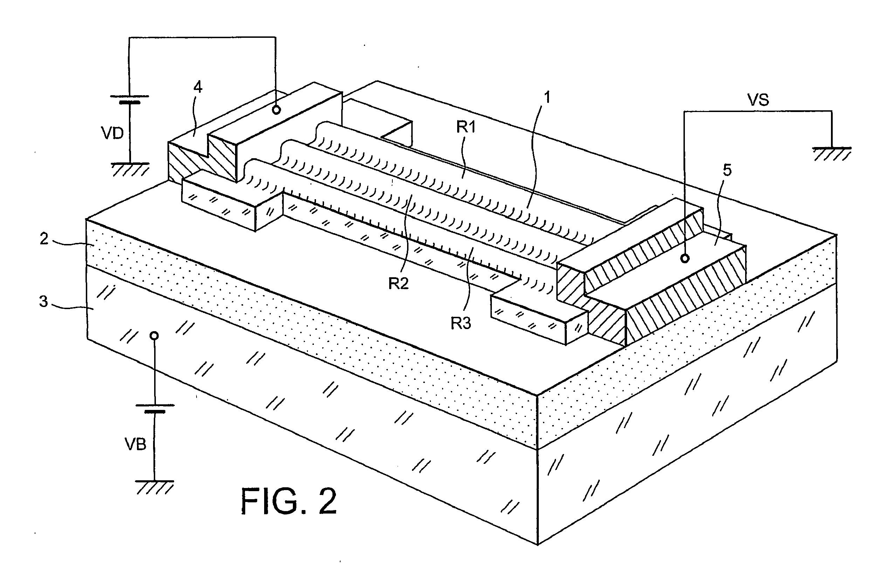

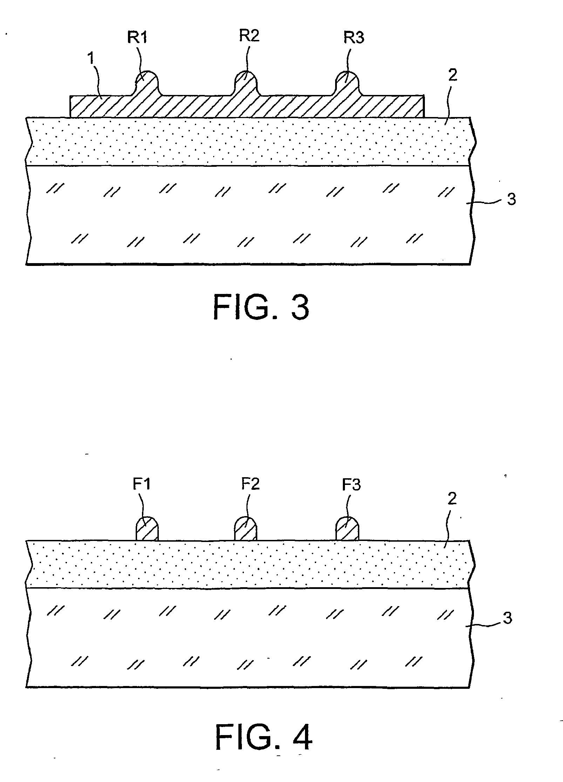

La figure 2 représente un exemple de nano-structure filaire obtenue suite au passage d'un courant dans un film mince de semi-conducteur tel que représenté en figure 1 et la figure 3 est une vue en coupe transversale de la nano-structure filaire représentée en figure 2.

Pour le passage du courant, la borne 4 est reliée à un potentiel VD, la borne 5 à un potentiel de référence VS (par exemple la masse du circuit), et la couche épaisse de silicium monocristallin 3 à un potentiel de substrat VB.

La différence de potentiel VD-VS conduit à l'apparition d'un courant dans le film semi-conducteur 1. De façon inattendue, la couche mince de silicium monocristallin 1 voit sa structure se modifier lors du passage du courant. Cette modification consiste en l'apparition de surépaisseurs qui se forment selon la direction du courant qui parcourt le film.

L'exemple de la figure 2 représente des surépaisseurs linéaires. L'invention concerne également d'autres formes de surépaisseurs dues au fait que la direction du courant qui parcourt le film n'est pas nécessairement linéaire mais peut présenter d'autres formes.

Dans l'exemple choisi, la modification de la structure est apparue pour une différence de potentiel VD-VS supérieure à 15V correspondant à une valeur de densité de courant J sensiblement égale à 2.10⁶ A.cm². Selon l'exemple choisi, les surépaisseurs sont au nombre de 3, R1, R2, R3. Elles ont chacune une largeur sensiblement égale à 45nm et une hauteur sensiblement égale à 7nm. La formation des surépaisseurs est due au fait que la conductivité du film mince de silicium monocristallin n'est pas uniforme. Des zones de conductivité élevée conduisent à une migration de matière et, partant, à la formation des surépaisseurs. La migration de matière s'effectue selon la direction du champ électrique, dans le sens opposé à celui du courant d'électrons, contrairement à ce qui se passe lors du phénomène d'électro-migration avec les métaux. Les zones de surépaisseurs sont stables dans le temps. Il a ainsi été observé, après une durée de 30mn, que ces zones ne varient pas de façon significative et que la valeur du courant qui les parcourt est sensiblement la même. Une application de différence de potentiel de 20V a conduit à la défaillance du circuit.

De façon générale, il a été constaté que le temps de passage du courant n'intervient pas dans la formation des surépaisseurs. Seule la densité du courant dans le film semi-conducteur monocristallin est à contrôler. La gamme des densités de courant aptes à la formation des surépaisseurs dépend du semi-conducteur. La valeur maximale est donnée par la limite au delà de laquelle il y a une défaillance du circuit. Dans le cas du silicium, les surépaisseurs apparaissent pour une densité de courant sensiblement comprise entre 2.10⁶A.cm² et 4.10¹⁸ A.cm². La concentration en dopants est adaptée de façon à obtenir la densité de courant suffisante pour produire la migration de matière. Dans le cas du silicium, le dopage peut être, par exemple sensiblement égal à 8 E18/cm³.

La figure 4 représente une étape supplémentaire pour la formation de nano-fils à partir de la nano-structure filaire représentée aux figures 2 et 3. Le film mince 1 présent entre les surépaisseurs R1, R2, R3 est alors gravé de sorte à former des nano-fils F1, F2, F3 en surface de la couche de silice 2.

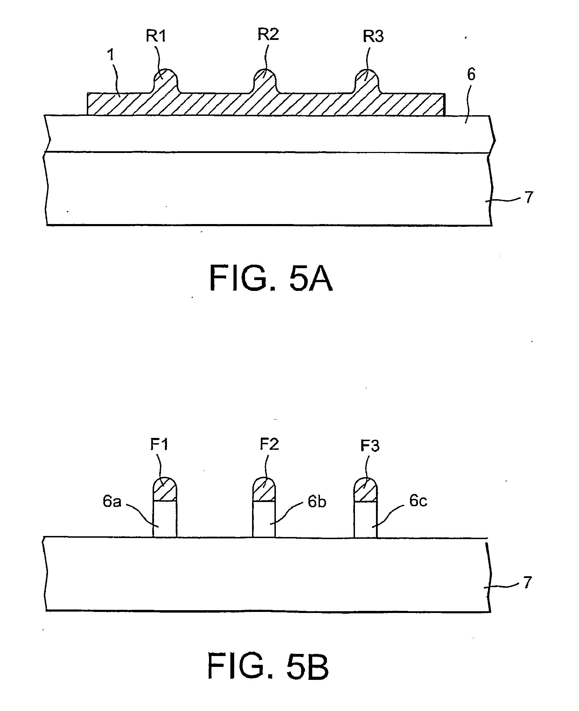

Les figures 5A et 5B représentent des étapes de gravure utilisant la nano-structure filaire obtenue précédemment comme masque de gravure. La nano-structure filaire est tout d'abord reportée sur un empilement de couches 6, 7 (cf. figure 5A). Une gravure du film mince 1 et de la couche 6 préente entre les surépaisseurs R1, R2, R3 conduit à la formation de nano-fils F1, F2, F3 portés par des nano-structures respectives 6a, 6b, 6c (cf. figure 5B). Il est également possible d'obtenir une structure telle que représentée en figure 5B par transfert des seuls fils F1, F2, F3 sur la couche 6. Par ailleurs, dans le cas où il n'existe pas de procédé de gravure sélectif de la couche 6 par rapport au film mince semi-conducteur 1, il est également possible de faire appel, de façon connue en technologie SOI (SOI pour "Silicon On Insulator"), à une couche intermédiaire sur laquelle la nano-structure est transférée avant l'étape de gravure de la couche 6.

Selon le mode de réalisation préférentiel de l'invention décrit ci-dessus, le semi-conducteur est du silicium monocristallin dopé n.

Selon d'autres modes de réalisation de l'invention, le semi-conducteur peut être dopé n ou p. Il peut être du silicium, mais également un alliage SiGe ou SiGeC. Le semi-conducteur peut également être non dopé. Dans le cas de semi-conducteur non dopé, le courant à l'origine de la migration de matière est obtenu par la création d'une densité de porteurs grâce à l'influence électrostatique d'une grille, par exemple en silicium polycristallin ou en métal, située à proximité du film mince semi-conducteur. A titre d'exemple non limitatif, le substrat sur lequel est formé le film mince semi-conducteur peut également jouer le rôle de cette grille et, dans ce cas, l'épaisseur du film semi-conducteur est très faible, par exemple égale à quelques nanomètres.

## Revendications

1. Procédé de fabrication de nano-structure filaire, **caractérisé en ce qu'**il comprend :
- la fabrication d'un film mince semi-conducteur (1) s'étendant entre une première borne (4) et une deuxième borne (5),
- le passage d'un courant entre la première et la deuxième borne de façon à former au moins une surépaisseur continue (R1, R2, R3) dans le film mince semi-conducteur, par migration, sous l'action du courant, d'une fraction du matériau semi-conducteur, la surépaisseur continue se formant selon la direction du courant qui parcourt le film, et,
- après la formation de la dite surépaisseur continue, la gravure du film mince pour former au moins un nano-fil (F1, F2, F3) à partir de la ou des surépaisseur(s) continues (R1, R2, R3).

2. Procédé selon la revendication 1, **caractérisé en ce que** le film mince semi-conducteur est obtenu par lithographie et/ou gravure d'une couche mince de semi-conducteur formée sur une couche d'isolant.

3. Procédé selon l'une quelconque des revendications précédentes, **caractérisé en ce que** le film mince semi-conducteur est un film mince de Si, ou de SiGe ou de SiGeC.

4. Procédé selon l'une quelconque des revendications précédentes, **caractérisé en ce que** le semi-conducteur est dopé.

5. procédé selon l'une quelconque des revendications précédentes, **caractérisé en ce que** le semi-conducteur est monocristallin.

6. Procédé de gravure de couche par masque dur, **caractérisé en ce qu'**il utilise comme masque dur une nano-structure filaire obtenue par un procédé de fabrication selon l'une quelconque des revendications 1 à 5.

## Claims

1. Process for manufacturing nanowire structures, **characterised in that** it comprises:
- manufacture of a thin semiconductor film (1) extending between a first terminal (4) and a second terminal (5), and
- passage of a current between the first and the second terminals so as to form at least one continuous overthickness (R1, R2, R3) in the thin semiconductor film by migration of a fraction of the semiconductor material under the action of the current, the continuous overthickness being formed along the direction of the current that passes through the film, and
- after formation of said continuous overthickness, etching of the thin film to form at least one nanowire (F1, F2, F3) from the continuous overthickness(es) (R1, R2, R3).

2. Process according to claim 1, **characterised in that** the thin semiconductor film is obtained by lithography and/or etching of a thin semiconductor layer formed on an insulating layer.

3. Process according to any one of the above claims, **characterised in that** the thin semiconductor film is a thin film of Si, SiGe or SiGeC.

4. Process according to any one of the above claims, **characterised in that** the semiconductor is doped.

5. Process according to any one of the above claims, **characterised in that** the semiconductor is monocrystalline.

6. Process for etching a layer using a hard mask, **characterised in that** the hard mask used is a nanowire structure obtained by a manufacturing process according to any one of claims 1 to 5.

## Patentansprüche

1. Verfahren zur Herstellung einer drahtförmigen Nanostruktur, **dadurch gekennzeichnet, dass** sie umfasst:
- das Herstellen eines Halbleiter-Dünnfilms (1), der sich zwischen einem ersten Anschluss (4) und einem zweiten Anschluss (5) erstreckt,
- das Fließen eines Stroms zwischen dem ersten und dem zweiten Anschluss, so dass sich in dem Halbleiter-Dünnfilm durch Migration eines Teils des Halbleitermaterials unter der Wirkung des Stroms wenigstens eine kontinuierliche Überdicke (R1, R2, R3) bildet, wobei die kontinuierliche Überdicke sich gemäß der Richtung des den Dünnfilm durchfließenden Stroms bildet, und
- das Ätzen des Dünnfilms nach der Bildung der genannten kontinuierlichen Überdicke, um aus der (oder den) kontinuierlichen Überdicke(n) (R1, R2, R3) wenigstens einen Nanodraht (F1, F2, F3) zu formen.

2. Verfahren nach Anspruch 1, **dadurch gekennzeichnet, dass** der Halbleiter-Dünnfilm durch Lithographie und/oder Ätzung einer auf einer isolierenden Schicht gebildeten Halbleiter-Dünnschicht realisiert wird.

3. Verfahren nach einem der vorangehenden Ansprüche, **dadurch gekennzeichnet, dass** der Halbleiter-Dünnfilm ein Si- oder SiGe- oder SiGeC-Dünnfilm ist.

4. Verfahren nach einem der vorangehenden Ansprüche, **dadurch gekennzeichnet, dass** der Halbleiter dotiert ist.

5. Verfahren nach einem der vorangehenden Ansprüche, **dadurch gekennzeichnet, dass** der Halbleiter monokristallin ist.

6. Hartmasken-Ätzverfahren, **dadurch gekennzeichnet, dass** als Hartmaske eine drahtförmige Nanostruktur benutzt wird, realisiert durch ein Herstellungsverfahren nach einem der Ansprüche 1 bis 5.
